# EUROPÄISCHE PATENTSCHRIFT

(11) **EP 3 032 429 B1**
(45) Veröffentlichungstag und Bekanntmachung des Hinweises auf die Patenterteilung: **11.11.2020**
(21) Anmeldenummer: 15184165.7
(22) Anmeldetag: 08.09.2015
(51) Int. Cl.: G06F 13/42

(54) **VERFAHREN UND VORRICHTUNG ZUM EINLESEN EINES SERIELLEN DATENSTROMS**
METHOD AND DEVICE FOR READING A SERIAL DATA STREAM
PROCEDE ET DISPOSITIF DESTINES A LA LECTURE D'UN FLUX SERIEL DE DONNEES

(30) Priorität: 08.12.2014 DE 102014225084
(43) Veröffentlichungstag der Anmeldung: 15.06.2016
(73) Patentinhaber: Dr. Johannes Heidenhain GmbH, 83301 Traunreut (DE)
(72) Erfinder: SCHENZINGER, Daniel, 83349 Palling-Freutsmoos (DE); KREUZER, Stephan, 83362 Surberg-Ettendorf (DE)

(56) Entgegenhaltungen:
- EP-A2- 0 187 342
- EP-A2- 0 289 237
- JP-A- 2009 267 646
- "Kapitel 1.2" In: Bernd Schürmann: "Rechnerverbindungsstrukturen", 31. Dezember 1997 (1997-12-31), Vieweg, Braunschweig/Wiesbaden, XP002756101, ISBN: 3-528-05562-6 Seiten 64-83, * Seite 64 - Seite 83 *

## Beschreibung

### BEZEICHNUNG DER ERFINDUNG

Verfahren und Vorrichtung zum Einlesen eines seriellen Datenstroms

### GEBIET DER TECHNIK

Die vorliegende Erfindung betrifft ein Verfahren zum Einlesen eines seriellen Datenstroms nach Anspruch 1, sowie eine korrespondierende Vorrichtung nach Anspruch 8.

Das erfindungsgemäße Verfahren, sowie Vorrichtungen zur Ausführung dieses Verfahrens, sind besonders für den Einsatz in Geräten der Automatisierungstechnik geeignet.

### STAND DER TECHNIK

Typische Geräte der Automatisierungstechnik sind Positionsmesseinrichtungen und die Folgeelektroniken, an denen sie betrieben werden. Bei den Folgeelektroniken kann es sich beispielsweise um numerische Werkzeugmaschinensteuerungen oder um komplexe Anlagensteuerungen handeln.

Positionsmesseinrichtungen werden beispielsweise dafür eingesetzt, bei geregelten Antrieben Lageistwerte zu ermitteln, die eine Folgeelektronik, beispielsweise eine numerische Steuerung, benötigt, um Sollwerte für Regelkreise zu berechnen, mit denen der Antrieb (z.B. Vorschub eines Werkzeugs oder eines Werkstückes) kontrolliert wird. Handelt es sich bei den Positionsmesseinrichtungen um Drehgeber oder Winkelmessgeräte, so sind diese hierzu beispielsweise direkt oder indirekt mit der Welle eines Motors gekoppelt. Längenmessgeräte messen beispielsweise lineare Bewegungen zwischen einem Maschinenbett und einem relativ zum Maschinenbett positionierbaren Maschinenteil, beispielsweise einem verfahrbaren Werkzeugschlitten.

Heutzutage kommen vorzugsweise absolute Positionsmesseinrichtungen zum Einsatz. Diese erzeugen absolute Messwerte, die über digitale, meist serielle Datenschnittstellen von der Positionsmesseinrichtung zur Folgeelektronik übertragen werden. Bei den Messwerten handelt es sich meist um Positionswerte (Winkelwerte oder lineare Positionen), es sind aber auch Positionsmesseinrichtungen bekannt, die Geschwindigkeits- oder Beschleunigungswerte liefern, also Messwerte, die die zeitliche Änderung von Positionen angeben.

Insbesondere bei großen oder räumlich weit verteilten Anlagen sind für die Datenübertragung zwischen Messgeräten und deren Folgeelektroniken häufig große Distanzen zu überbrücken. Dies führt dazu, dass sich die Signalqualität der digitalen Signale über die Leitungslänge verschlechtert, so dass es empfängerseitig schwieriger wird, eintreffende Datenströme korrekt einzulesen.

Dem kann durch den Einsatz hochwertiger Datenkabel entgegengewirkt werden, was allerdings dazu führt, dass die Kosten für das Gesamtsystem signifikant steigen.

Eine weitere Möglichkeit, trotz großer Kabellängen eine zuverlässige Datenübertragung zu erreichen, ist es, die Datenübertragungsrate zu reduzieren. Dies beeinträchtigt aber die Dynamik von Regelkreisen, die beispielsweise Positionswerte von Positionsmesseinrichtungen als LageIstwerte benötigen, um neue Lage-Sollwerte berechnen zu können.

Die WO 03/067804 A1 schlägt vor, empfängerseitig eine Bitfehlerrate zu bestimmen und in Abhängigkeit davon Maßnahmen zu ergreifen, wie z.B. eine Wiederholung der Übertragung anzufordern, oder die Länge zu übertragender Datenpakete zu reduzieren. Auch diese Maßnahmen haben negative Auswirkung auf den Betrieb dynamischer Regelkreise.

EP0289237 offenbart einen Empfänger für Manchester-kodierte Signale, welcher ein Zwischensignal generiert unter Berücksichtigung eines verzögerten und eines aktuellen Empfangssignals.

### ZUSAMMENFASSUNG DER ERFINDUNG

Es ist Aufgabe der vorliegenden Erfindung, ein Verfahren zum Einlesen eines seriellen Datenstroms in einem Gerät der Automatisierungstechnik zu schaffen.

Diese Aufgabe wird gelöst durch ein Verfahren nach Anspruch 1.

Es wird ein Verfahren zum Einlesen eines seriellen Datenstroms in einem Gerät der Automatisierungstechnik vorgeschlagen, wobei der Datenstrom in einer Weise codiert ist, dass er wenigstens zwei Symbole umfasst, die durch den zeitlichen Abstand zwischen zwei aufeinanderfolgenden Signalflanken unterscheidbar sind und der Datenstrom einer Leseeinheit zugeführt ist, die eine Symbol-Erkennungseinheit umfasst, die der zeitlichen Abfolge der Signalflanken Symbole zuordnet, wobei für die Zuordnung eines Symbols ein Zeitraum berücksichtigt wird, der eine aktuelle Symboldauer des aktuell zuzuordnenden Symbols und wenigstens eine alte Symboldauer des vorhergehenden Symbols umfasst.

Weiter ist es Aufgabe der vorliegenden Erfindung, eine Vorrichtung zum Einlesen eines seriellen Datenstroms in einem Gerät der Automatisierungstechnik zu schaffen.

Diese Aufgabe wird gelöst durch eine Vorrichtung nach Anspruch 8.

Hier wird eine Vorrichtung zum Einlesen eines seriellen Datenstroms in einem Gerät der Automatisierungstechnik vorgeschlagen, wobei der Datenstrom in einer Weise codiert ist, dass er wenigstens zwei Symbole umfasst, die durch den zeitlichen Abstand zwischen zwei aufeinanderfolgenden Signalflanken unterscheidbar sind und der Datenstrom einer Leseeinheit zugeführt ist, die eine Symbol-Erkennungseinheit umfasst, die der zeitlichen Abfolge der Signalflanken Symbole zuordnet, wobei in der Symbol-Erkennungseinheit ein Symbol unter Berücksichtigung eines Zeitraums, der eine aktuelle Symboldauer des aktuell zuzuordnenden Symbols und wenigstens eine alte Symboldauer des vorhergehenden Symbols umfasst, zuordenbar ist.

Die aktuelle Symboldauer wird also durch den zeitlichen Abstand der beiden zuletzt bei der Symbol-Erkennungseinheit eingetroffenen Signalflanken bestimmt. Der Zeitraum, der für die Zuordnung eines Symbols zur aktuellen Symboldauer berücksichtigt wird, umfasst darüber hinaus noch wenigstens eine weitere vorausgehende Signalflanke.

Die Symbol-Erkennungseinheit umfasst eine Zuordnungseinheit, der
- die aktuelle Symboldauer und wenigstens die alte Symboldauer, oder
- eine Summe aus der aktuellen Symboldauer und wenigstens der alten Symboldauer, oder
- eine Summe aus der aktuellen Symboldauer und einer Abweichung wenigstens der alten Symboldauer von einer idealen Zeitdauer, oder
- eine Summe aus der aktuellen Symboldauer, der Abweichung wenigstens der alten Symboldauer von einer idealen Zeitdauer und einem Offsetwert
zugeführt ist. In der Zuordnungseinheit wird auf der Basis dieser Werte der aktuellen Symboldauer ein Symbol zugeordnet.

Zum Generieren der Werte, auf deren Basis die Zuordnung des Symbols erfolgt, sind in der Symbol-Erkennungseinheit geeignete Mittel vorgesehen.

Insbesondere können diese Mittel wenigstens eine Zeitmesseinheit zum Messen der Zeitdauer zwischen Signalflanken des einzulesenden Datenstroms, eine Recheneinheit zur Berechnung der erforderlichen Summen, Abweichungen, etc., sowie einen Messwertspeicher zum Zwischenspeichern von gemessenen Symboldauern umfassen. Den Mitteln kann von der Zuordnungseinheit die Information zugeführt sein, welches Symbol wenigstens der alten Symboldauer zugeordnet wurde.

Weitere Vorteile und Details eines erfindungsgemäßen Verfahrens, sowie einer korrespondierenden Vorrichtung ergeben sich aus der Beschreibung der nachfolgenden Ausführungsbeispiele.

### KURZE BESCHREIBUNG DER ZEICHNUNGEN

Es zeigt
- Figur 1: ein Blockdiagramm einer Positionsmesseinrichtung und einer Folgeelektronik, die über einen bidirektionalen Datenübertragungskanal miteinander verbunden sind,
- Figur 2: ein Signaldiagramm zur Erläuterung einer Manchester-Codierung,
- Figur 3: ein Blockdiagramm einer Schnittstelleneinheit der Positionsmesseinrichtung,
- Figur 4: einen Ausschnitt eines manchester-codierten Datenstroms,
- Figur 5: ein Blockdiagramm einer Schnittstelleneinheit der Folgeelektronik, korrespondierend zur in Figur 3 dargestellten Schnittstelleneinheit,
- Figur 6: ein Blockdiagramm einer alternativen Ausführung einer Schnittstelleneinheit der Positionsmesseinrichtung,
- Figur 7: ein Blockdiagramm einer weiteren alternativen Ausführung einer Schnittstelleneinheit der Positionsmesseinrichtung,
- Figur 8: ein Blockdiagramm einer weiteren alternativen Ausführung einer Schnittstelleneinheit der Positionsmesseinrichtung und
- Figur 9: ein Blockdiagramm einer weiteren alternativen Ausführung einer Schnittstelleneinheit der Positionsmesseinrichtung.

### BESCHREIBUNG DER AUSFÜHRUNGSFORMEN

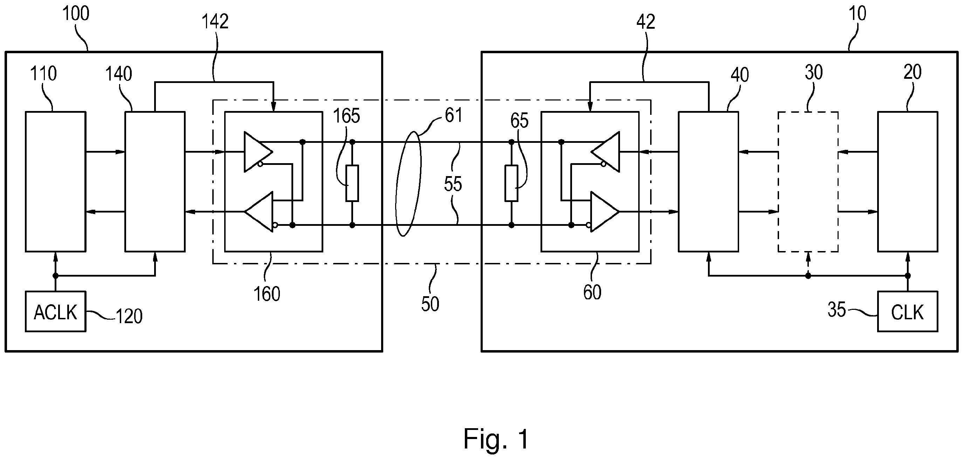

Figur 1 zeigt ein Blockdiagramm einer Positionsmesseinrichtung 10 und einer Folgeelektronik 100, die über einen Datenübertragungskanal 50 miteinander verbunden sind. Die Positionsmesseinrichtung 10 und die Folgeelektronik 100 stehen hierbei stellvertretend für Geräte der Automatisierungstechnik.

Die Positionsmesseinrichtung 10 weist Messgerätekomponenten in Form einer Positionserfassungseinheit 20 und einer optionalen Verarbeitungseinheit 30 auf. Die Positionserfassungseinheit 20 ist geeignet ausgestaltet, um digitale Positionswerte zu erzeugen. Sie umfasst hierzu beispielsweise eine Maßverkörperung mit einer Messteilung, eine Abtasteinheit für deren Abtastung, sowie eine Signalverarbeitungselektronik zur Bildung des digitalen Positionswerts aus Abtastsignalen der Abtasteinheit, die durch die Abtastung der Messteilung generiert werden. Maßverkörperung und Abtasteinheit sind in bekannter Weise relativ zueinander beweglich angeordnet und mechanisch mit Maschinenteilen verbunden, deren Position zueinander gemessen werden soll. Handelt es sich bei der Positionsmesseinrichtung 10 um einen Drehgeber, mit dem die Winkelposition der Welle eines Elektromotors gemessen werden soll, so ist die Abtasteinheit (bzw. das Gehäuse des Drehgebers) beispielsweise an einem Motorgehäuse angebracht und eine Welle des Drehgebers, die mit der Maßverkörperung drehfest verbunden ist, ist über eine Wellenkupplung mit der zu messenden Motorwelle verbunden.

Insbesondere um für die digitalen Schaltungsteile eine Zeitbasis, bzw. ein definiertes Zeitraster zur Verfügung zu stellen, ist in der Positionsmesseinrichtung 10 weiter ein Taktgenerator 35 angeordnet. Er liefert wenigstens ein Arbeitstaktsignal CLK, das digitalen Zustandsautomaten, Mikroprozessoren, Mikrokontrollern etc. zugeführt ist.

Das physikalische Abtastprinzip, das der Positionserfassungseinheit 20 zugrunde liegt, ist für die vorliegende Erfindung bedeutungslos. So kann es sich um ein optisches, magnetisches, kapazitives oder induktives Abtastprinzip handeln. Entsprechend den notwendigen Verarbeitungsschritten, die erforderlich sind, um die Abtastsignale der Abtasteinheit zu Positionswerten zu verarbeiten, umfasst die Signalverarbeitungselektronik Funktionseinheiten, die Verarbeitungsschritte wie Verstärkung, Signalkorrektur (Offset-, Amplituden-, Phasenkorrektur), Interpolation, Zählung von Teilungsperioden, A/D-Wandlung,... ausführen.

Für die Übertragung von Steuersignalen und/oder Daten zwischen der Positionserfassungseinheit 20 und der Verarbeitungseinheit 30 sind geeignete Signalleitungen vorgesehen. Sie dienen insbesondere dazu, die in der Positionserfassungseinheit 20 generierten Positionswerte zur Verarbeitungseinheit 30 zu übertragen.

In der Verarbeitungseinheit 30 werden die Positionswerte ggf. weiter verarbeitet um Ausgabedaten zu erhalten. Hierzu können Verarbeitungsschritte wie Skalierung, Änderung des Datenformats, Fehlerkorrektur, etc. erforderlich sein, die in der Verarbeitungseinheit 30 rein digital ausgeführt werden. Ausgabedaten können aber nicht nur Positionswerte, sondern auch Geschwindigkeits- oder Beschleunigungswerte sein, die in der Verarbeitungseinheit 30 aus mehreren, hintereinander erzeugten Positionswerten berechnet werden.

Zur Kommunikation mit der Folgeelektronik 100 einerseits und den Messgerätekomponenten 20, 30 andererseits ist in der Positionsmesseinrichtung 10 weiter eine Schnittstelleneinheit 40 angeordnet. Insbesondere erfolgt über die Schnittstelleneinheit 40 die Übertragung der Ausgabedaten zur Folgeelektronik 100. Die Ausgabedaten werden der Schnittstelleneinheit 40 über geeignete Signalleitungen von der Verarbeitungseinheit 30 oder der Positionserfassungseinheit 20 übermittelt. Auch der Schnittstelleneinheit 40 ist ein Taktsignal zugeführt, das als Zeitbasis für ihre internen Abläufe dient. Dabei kann es sich um das Arbeitstaktsignal CLK handeln.

Die physikalische Verbindung zur Übertragung von Befehlen und Daten zwischen der Schnittstelleneinheit 40 der Positionsmesseinrichtung 10 und einer korrespondierenden Schnittstelleneinheit 140 der Folgeelektronik 100 wird über den bidirektionalen Datenübertragungskanal 50 hergestellt. Hierzu sind dem Datenübertragungskanal 50 in der Positionsmesseinrichtung 10 eine Sende-/Empfängereinheit 60 und in der Folgeelektronik 100 eine korrespondierende Sende-/Empfängereinheit 160 zugeordnet, die wiederum über ein Schnittstellenkabel 61 miteinander verbunden sind. Die Sende-/Empfängereinheiten 60, 160 im vorliegenden Ausführungsbeispiel sind geeignet ausgestaltet um die jeweils zu sendenden Befehle und/oder Daten, die üblicherweise als massebezogene (single-ended) Signale vorliegen, in differentielle Signale, beispielsweise entsprechend dem weit verbreiteten RS-485-Standard, umzuwandeln und aus eintreffenden differentiellen Signalen massebezogene Signale zu generieren. Für die Signalübertragung zwischen den Sende-/Empfängereinheiten 60, 160 ist im Schnittstellenkabel 61 ein Leitungspaar 55 vorgesehen. Die beiden Leitungen des Leitungspaares 55 sind üblicherweise miteinander verdrillt, so dass Störeinflüsse, beispielsweise elektromagnetische Störfelder, die Signale beider Leitungen gleichermaßen stören. Da für die Auswertung lediglich die Differenz der Signale ausschlaggebend ist, ist diese Art der Signalführung sehr störunempfindlich. Jeweils an den Eingängen der Sende-/Empfängereinheiten 60, 160 sind Leitungs-Terminierungen 65, 165 zur Vermeidung von Signalreflektionen vorgesehen.

Der Datenübertragungskanal 50 ist in diesem Ausführungsbeispiel bidirektional ausgeführt. Die Datenrichtung der Sende-/Empfängereinheiten 60, 160 ist von den ihnen zugeordneten Schnittstelleneinheiten 40, 140 über ein Umschaltsignal 42, 142 einstellbar. Alternativ könnte der Datenübertragungskanal 50 aber auch unidirektional ausgeführt sein. In diesem Fall müssten im Schnittstellenkabel 61 für bidirektionale Signalübertragung zwei Leitungspaare vorgesehen sein.

Die Art und Weise, wie die Kommunikation zwischen Folgeelektronik 100 und Positionsmesseinrichtung 10 erfolgt, ist in einem Schnittstellenprotokoll festgelegt. Häufig kommt dabei ein sog. Frage-Antwort-Schema zum Einsatz, d.h. in einem Kommunikationszyklus sendet die Folgeelektronik 100 (Master) einen Befehl, ggf. gefolgt von Daten, zur Positionsmesseinrichtung 10 (Slave), diese bearbeitet den Befehl und sendet ggf. angeforderte Daten zur Folgeelektronik 100. Befehle können allgemein Schreib- und/oder Lesebefehle sein, beispielsweise zum Beschreiben oder Auslesen von Speicherzellen in der Verarbeitungseinheit 30. Für die Anforderung eines Positionswerts als Ausgangsdatum zur Folgeelektronik 100 kann ein spezieller Positionsanforderungsbefehl vorgesehen sein.

Wie alle Abläufe in der Folgeelektronik 100 werden auch Zugriffe auf die Positionsmesseinrichtung 10 von einer internen Steuereinheit 110 gesteuert. Handelt es sich bei der Folgeelektronik 100 um eine Numerische Steuerung oder ein sonstiges Steuergerät der Automatisierungstechnik, so fordert die Steuereinheit 110 über die Schnittstelleneinheit 140 beispielsweise kontinuierlich Positionswerte von der Positionsmesseinrichtung 10 an, um Positionsistwerte (Lageistwerte) zu erhalten, die sie für Regelkreise benötigt, etwa um mechanische Komponenten einer Maschine über einen Antrieb präzise zu positionieren (Servoantrieb).

Auch in der Folgeelektronik 100 ist ein Taktgenerator 120 angeordnet, der ein Arbeitstaktsignal ACLK generiert, das zur Bildung einer Zeitbasis, bzw. eines Zeitrasters der Steuereinheit 110 und der Schnittstelleneinheit 140 zugeführt ist.

Befehle und Daten werden von den Schnittstelleneinheiten 40, 140 in Form von Datenrahmen übertragen, die entsprechend den Definitionen des Datenübertragungsprotokolls aufgebaut sind. Üblicherweise werden Datenrahmen mit einer Startsequenz (Preamble) eingeleitet und mit einer Endsequenz (Postamble) abgeschlossen. Dazwischen sind die eigentlich zu übertragenden Daten und/oder Befehle angeordnet.

Erfindungsgemäß werden die Datenrahmen nicht uncodiert (also der Wert jedes zu übertragenden Bits mittels seines zugeordneten Signalpegels über eine definierte Signaldauer), sondern codiert übertragen. Zu diesem Zweck werden senderseitig auf den zu übertragenden Datenrahmen Codierungsregeln angewandt, bevor er in Form eines Datenstroms über den Datenübertragungskanal 50 übertragen wird. Analog hierzu werden empfängerseitig auf den eintreffenden Datenstrom Decodierungsregeln angewandt, um wieder den originalen Datenrahmen zu erhalten.

Die Codierung ist so ausgeführt, dass der Datenstrom wenigstens zwei Symbole umfasst, die durch den zeitlichen Abstand zwischen zwei aufeinanderfolgenden Signalflanken unterscheidbar sind. Dies trifft beispielsweise auf verschiedene Varianten der Manchester-Codierung zu.

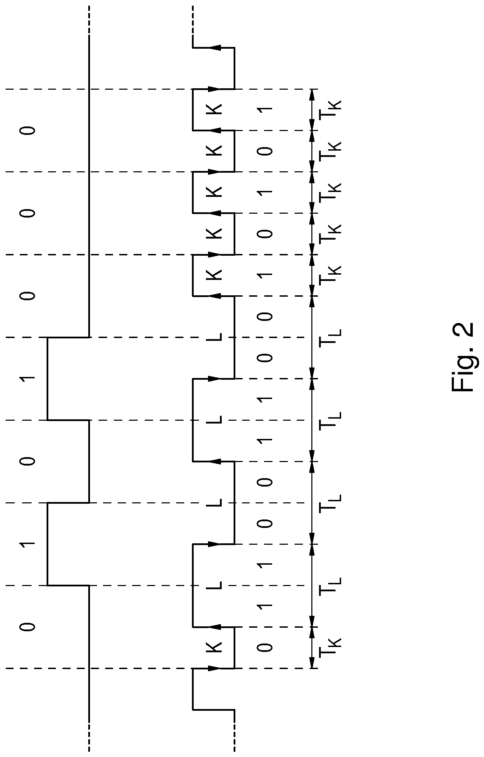

Figur 2 zeigt beispielsweise eine Manchester-Codierung, bei der eine logische "0" durch eine steigende Signalflanke (eine Bitfolge "01") und eine logische "1" durch eine fallende Signalflanke (eine Bitfolge "10") ersetzt wird. Dadurch wird aus der in Figur 2 oben dargestellten zu übertragenden Bitfolge "0101000" die codierte Bitfolge "01100110010101". Dies hat zum einen den Vorteil, dass durch den zwingend auftretenden Pegelwechsel je zu übertragendem Bit eine Überprüfung der Datenübertragung ermöglicht wird, zum anderen ist die codierte Bitfolge gleichanteilsfrei, was es ermöglicht, durch Modulationsverfahren die codierte Bitfolge und eine Versorgungsspannung über das gleiche Leitungspaar 55 zu übertragen.

Durch die dargestellte Codierung ergibt sich (wenn der ursprünglichen Bitfolge jeweils ein logischer Low-Pegel vorausgeht und nachfolgt) für den codierten Datenstrom eine Abfolge von kurzen Symbolen K mit einer idealen Symboldauer T_{K} und langen Symbolen L mit einer idealen Symboldauer T_{L}, in diesem Beispiel "KLLLLKKKKK".

Neben der gezeigten Variante der Manchester-Codierung ist selbstverständlich auch eine umgekehrte Zuordnung der Signalflanken zu den logischen Pegeln möglich. Ebenso geeignet ist die differentielle Manchestercodierung.

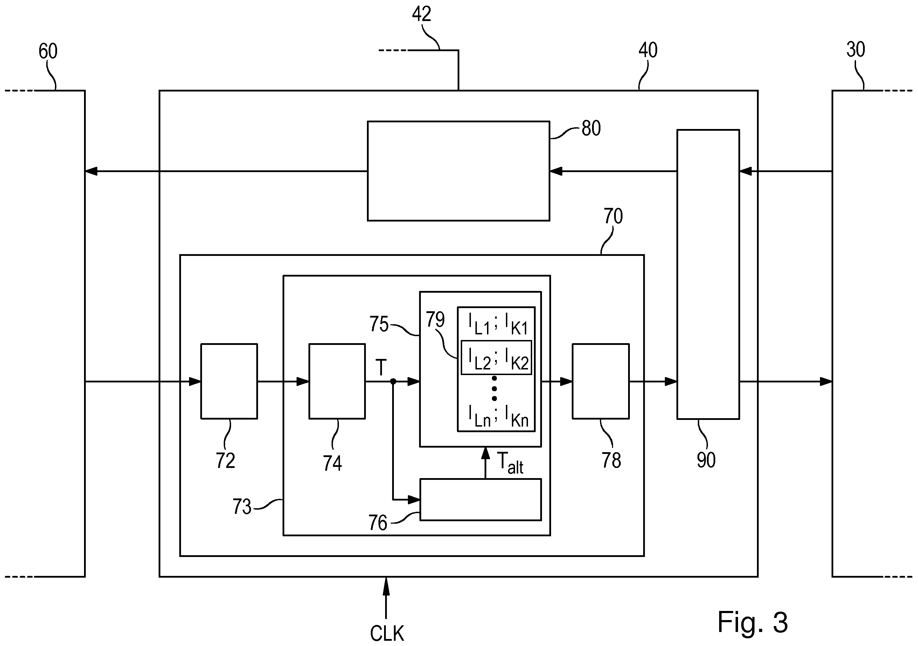

Figur 3 zeigt nun ein Blockdiagram einer Schnittstelleneinheit 40. Sie umfasst eine Leseeinheit 70, eine Ausgabeeinheit 80, sowie eine Kommunikationseinheit 90.

Die Leseeinheit 70 dient zum Einlesen und Verarbeiten von eintreffenden Datenströmen. Sie umfasst eine Synchronisationseinheit 72, eine Symbol-Erkennungseinheit 73 und eine Auswerteeinheit 78.

Die Synchronisationseinheit 72 ist der Symbol-Erkennungseinheit 73 vorgeschaltet. Sie synchronisiert den eintreffenden Datenstrom mit dem Arbeitstaktsignal CLK und gibt den synchronisierten Datenstrom, der nun das zeitliche Raster des Arbeitstaktsignals CLK aufweist, an die Symbol-Erkennungseinheit 73 aus. Die Synchronisationseinheit 72 kann hierzu beispielsweise ein oder mehrere D-Flip-Flops umfassen, deren Takteingang mit dem Arbeitstaktsignal CLK betrieben wird.

Die Symbol-Erkennungseinheit 73 ermittelt aus dem synchronen Datenstrom die Symbolfolge und gibt die Information, in welcher Abfolge die Symbole K, L mit dem Datenstrom eintreffen, an die Auswerteeinheit 78 aus, die wiederum die Symbolfolge auswertet, decodiert und die enthaltenen Nutzdaten an die Kommunikationseinheit 90 ausgibt.

Der Inhalt der mit dem eintreffenden Datenstrom übertragenen Datenrahmen ändert sich durch diese Verarbeitungsschritte nicht.

Die Kommunikationseinheit 90 gibt Befehle und ggf. Daten, die in empfangenen Datenrahmen enthalten sind, an die jeweils adressierte(n) Zielkomponente(n) (z.B. Positionserfassungseinheit 20, Verarbeitungseinheit 30,...) weiter. Darüber hinaus empfängt die Kommunikationseinheit 90, beispielsweise von der Positionserfassungseinheit 20 oder der Verarbeitungseinheit 30, zu sendende Daten, bildet wiederum hieraus einen Datenrahmen und gibt ihn an eine Ausgabeeinheit 80 der Schnittstelleneinheit 40 aus. In dieser Datenrichtung fungieren die Verarbeitungseinheit 30 und/oder die Positionserfassungseinheit 20 als Quellkomponenten für die Datenübertragung.

Die Ausgabeeinheit 80 ist geeignet ausgestaltet, um den Datenrahmen ggf. zu ergänzen, zu codieren und über den Datenübertragungskanal 50 auszugeben. Die Funktionen der Ausgabeeinheit 80 sind nicht Teil der vorliegenden Erfindung und werden daher nicht näher erläutert.

Der Ermittlung der Symbolfolge in der Symbol-Erkennungseinheit 73 liegen in diesem Ausführungsbeispiel nun zwei wesentliche Schritte zugrunde: zum einen das Messen des zeitlichen Abstands zwischen zwei aufeinanderfolgenden Signalflanken (im Folgenden als aktuelle Symboldauer T bezeichnet) mit einer Zeitmesseinheit 74, und zum anderen das Zuordnen eines Symbols K, L durch Vergleich der aktuellen Symboldauer T mit den Symbolen K, L zugeordneten Entscheidungsintervallen in einer Zuordnungseinheit 75.

Die Zeitmesseinheit 74 kann beispielsweise durch einen Zählerbaustein realisiert werden, dessen Zähleingang (Takteingang) mit dem Arbeitstaktsignal CLK beaufschlagt ist und der so beschaltet ist, dass jede Signalflanke des synchronisierten Datenstroms bewirkt, dass der Zählerstand des Zählerbausteins erst an die Zuordnungseinheit 75 ausgegeben und ggf. in einem Messwertspeicher 76 abgespeichert wird und anschließend der Zählerbaustein zurückgesetzt wird (Reset).

In der Zuordnungseinheit 75 sind jedem Symbol K, L wenigstens zwei, allgemein betrachtet n Entscheidungsintervalle I_{L1}, I_{K1}; I_{L2}, I_{K2}; ... ; I_{Ln}, I_{Kn} zugeordnet. Entscheidend für die vorliegende Erfindung ist dabei, dass für den Vergleich und die daraus resultierende Zuordnung des Symbols K, L die Entscheidungsintervalle I_{L1}, I_{K1}; I_{L2}, I_{K2}; ... ; I_{Ln}, I_{Kn} in Abhängigkeit vom gemessenen zeitlichen Abstand der vorhergehenden Messung (im Folgenden als alte Symboldauer Tₐₗₜ bezeichnet) ausgewählt werden. Hierfür ist vorgesehen, den im Messwertspeicher 76 gespeicherten Messwert als alte Symboldauer Tₐₗₜ der Zuordnungseinheit 75 zuzuführen. Für die Zuordnung eines Symbols K, L zur aktuellen Symboldauer T wird also ein Zeitraum berücksichtigt, der die alte Symboldauer Tₐₗₜ mit einschließt.

Da die alte Symboldauer Tₐₗₜ ebenfalls ein Symbol K, L repräsentiert, setzt sie sich aus einem konstanten Teil (der idealen Symboldauer des der alten Symboldauer Tₐₗₜ zugrunde liegenden Symbols K, L) und einem variablen Teil (der Abweichung der alten Symboldauer Tₐₗₜ von der idealen Symboldauer T_{K}, T_{L} des ihm zugrunde liegenden Symbols K, L) zusammen.

Um die Auswahl der Entscheidungsintervalle I_{L1}, I_{K1}; I_{L2}, I_{K2}; ... ; I_{Ln}, I_{Kn} in der Zuordnungseinheit 75 zu vereinfachen, können Rechenmittel vorgesehen sein, um die alte Symboldauer Tₐₗₜ auf ihre Abweichung ΔTₐₗₜ von einer idealen Symboldauer T_{K}, T_{L} zu reduzieren. Für die Auswahl der Entscheidungsintervalle I_{L1}, I_{K1}; I_{L2}, I_{K2}; ... ; I_{Ln}, I_{Kn} ist somit, unabhängig vom vorhergehenden Symbol, nur noch ein Zahlenwert zu berücksichtigen. War das der alten Symboldauer Tₐₗₜ zugrunde liegende Symbol beispielsweise ein kurzes Symbol K, so errechnet sich die Abweichung als ΔTₐₗₜ = Tₐₗₜ -T_{K}, war das Symbol ein langes Symbol L, so gilt: ΔTₐₗₜ = Tₐₗₜ - T_{L}. Die Abweichung ΔTₐₗₜ kann als Zeiger auf die auszuwählenden Entscheidungsintervalle I_{L1}, I_{K1}; I_{L2}, I_{K2}; ... ; I_{Ln}, I_{Kn} verwendet werden. So wurden in Figur 3 beispielsweise die Entscheidungsintervalle I_{L2}, I_{K2} ausgewählt.

Bei dieser Vorgehensweise kann die Abweichung ΔTₐₗₜ negative Werte annehmen. Dies führt bei der Realisierung der Zuordnungseinheit 75 als Teil der Schnittstelleneinheit 40 in einer digitalen Schaltung (beispielsweise in einem FPGA, ASIC oder Mikrocontroller) zu einem höheren Aufwand, als wenn nur positive Werte zu verarbeiten wären, das Vorzeichen also unberücksichtigt bleiben könnte. Um trotzdem unabhängig vom vorhergehenden Symbol zu werden und die Auswahl basierend auf nur einem Zahlenwert vornehmen zu können, kann zur Abweichung ΔTₐₗₜ wieder eine Konstante als Offsetwert addiert werden, so dass der Zahlenwert sicher in den Bereich der positiven Zahlen verschoben wird.

Einfacher ist es aber, die ideale Symboldauer entweder eines kurzen Symbols T_{K}, oder eines langen Symbols T_{L} als Offsetwert anzunehmen. In diesem Fall muss nur dann eine Rechenoperation vorgenommen werden, wenn das Symbol, dass der alten Symboldauer Tₐₗₜ zugrunde liegt, verschieden von demjenigen ist, das als Offsetwert gewählt wurde.

Wird also beispielsweise die ideale Symboldauer eines kurzen Symbols T_{K} als Offsetwert gewählt, so muss nichts getan werden, wenn das Symbol, das der alten Symboldauer Tₐₗₜ zugrunde liegt, ein kurzes Symbol K ist, da bereits gilt: Tₐₗₜ = ΔTₐₗₜ + T_{K}. Liegt dagegen der alten Symboldauer Tₐₗₜ ein langes Symbol L zugrunde, so kann dieses durch Subtraktion der idealen Symboldauer eines kurzen Symbols T_{K} (unter der Voraussetzung dass, wie bei dem vorliegenden Beispiel gegeben, gilt: T_{L} = 2 * T_{K}) auf einen Zahlenwert reduziert werden, der ebenfalls ΔTₐₗₜ + T_{K} entspricht.

Entsprechende Vorgehensweisen sind auch dann möglich, wenn die idealen Symboldauern der Symbole in einem anderen Verhältnis zueinander stehen. Die Rechenmittel in der Zuordnungseinheit 75 sind jeweils entsprechend auszugestalten.

Allen genannten Ausführungsvarianten liegt das Prinzip zugrunde, einer aktuellen Symboldauer T in Abhängigkeit von der Abweichung ΔTₐₗₜ der Symboldauer Tₐₗₜ des vorhergehenden Symbols K, L von einer idealen Symboldauer T_{K}, T_{L} ein Symbol K, L zuzuordnen. Es wird also immer ein Zeitraum berücksichtigt, der neben der aktuellen Symboldauer T auch die alte Symboldauer Tₐₗₜ mit umfasst.

Das Ergebnis der oben ausgeführten Varianten lässt sich noch verbessern, wenn zusätzlich zu der alten Symboldauer Tₐₗₜ des vorhergehenden Symbols noch weitere vorausgegangene Symboldauern in der Zuordnungseinheit 75 mit einbezogen werden, der berücksichtigte Zeitraum wird also auf weitere vorausgegangene Symboldauern ausgedehnt. Hierzu ist die Speichereinheit 76 so zu dimensionieren, dass mehrere alte Symboldauern speicherbar und der Zuordnungseinheit 75 zuführbar sind. Außerdem sind die Rechenmittel in der Zuordnungseinheit 75 geeignet auszugestalten, um die Abweichungen aller einzubeziehender alter Symboldauern von den idealen Symboldauern aufzusummieren. Da die Abweichungen der tatsächlichen Symboldauern von den idealen Symboldauern unter anderem von der Aufladung des Schnittstellenkabels 61 abhängig sind, ist beim Aufsummieren das Vorzeichen der Abweichungen zu berücksichtigen. Die Abweichungen älterer Symboldauern können dabei schwächer gewichtet werden als diejenigen, die der aktuellen Symboldauer unmittelbar vorausgehen.

Die Entscheidungsintervalle I_{L1}, I_{K1}; I_{L2}, I_{K2}; ... ; I_{Ln}, I_{Kn} sind in der Zuordnungseinheit 75 in einer Speichereinheit 79 speicherbar. Mit Vorteil können die Entscheidungsintervalle I_{L1}, I_{K1}; I_{L2}, I_{K2}; ... ; I_{Ln}, I_{Kn} bei der Inbetriebnahme in der Speichereinheit 79 installationsabhängig gespeichert werden. Alternativ kann vorgesehen sein, mehrere Sätze von Entscheidungsintervallen I_{L1}, I_{K1}; I_{L2}, I_{K2}; ... ; I_{Ln}, I_{Kn} in der Speichereinheit 79 zu speichern und, beispielsweise in Abhängigkeit von der Installation, wählbar auszuführen. Kriterien zur Auswahl eines Satzes von Entscheidungsintervallen I_{L1}, I_{K1}; I_{L2}, I_{K2}; ... ; I_{Ln}, I_{Kn} können beispielsweise die Eigenschaften und Länge des Schnittstellenkabels 61 und/oder die gewünschte Datenübertragungsrate sein.

Weiter kann vorgesehen sein, die Entscheidungsintervalle I_{L1}, I_{K1}; I_{L2}, I_{K2}; ... ; I_{Ln}, I_{Kn} dynamisch veränderbar auszuführen und die Grenzwerte, beispielsweise bei der Inbetriebnahme oder während der Hochlaufphase nach dem Einschalten, für den jeweiligen Anwendungsfall zu ermitteln und in der Speichereinheit 79 abzuspeichern.

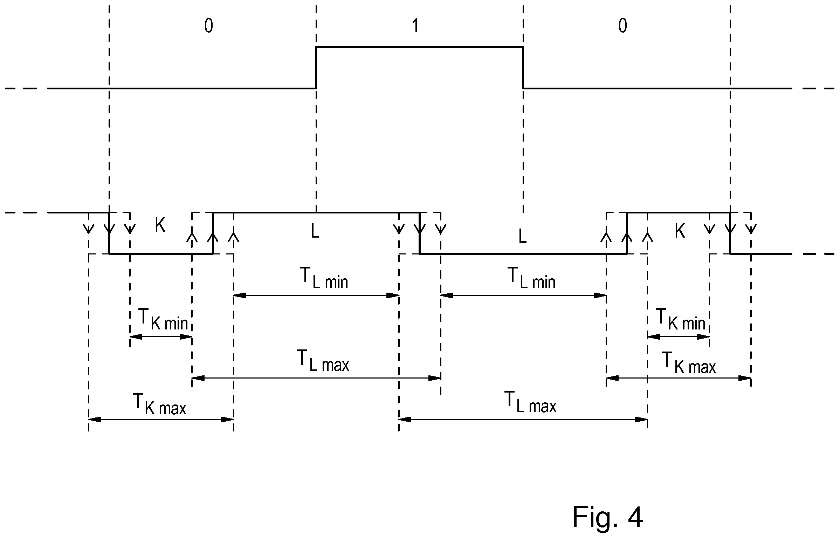

Figur 4 zeigt zur weiteren Erläuterung der Problematik einen Ausschnitt eines manchester-codierten Datenstroms. Die zugrundeliegende uncodierte Bitfolge "010" ist im oberen Teil der Figur 4 dargestellt. Unter der Annahme, dass vor und nach dieser Bitfolge ebenfalls eine logische "0" übertragen wird, ergibt sich die manchester-codierte Symbolfolge "KLLK". Die Übertragung dieser Symbolfolge über den Datenübertragungskanal 50 führt dazu, dass empfängerseitig die Dauer der Symbole L, K nicht immer gleich ist, sondern über einen Zeitraum variiert. Eine der Ursachen hierfür ist das Schnittstellenkabel 61, über das der Datenstrom übertragen wird. Es weist sowohl kapazitive, als auch induktive Eigenschaften auf, so dass bei jedem Pegelwechsel (Bitwechsel) Lade- und Entladevorgänge, sowie Einschwingvorgänge stattfinden, die zum einen die Signalflanken abflachen und zum anderen Über- und Unterschwingen des Datensignals hervorrufen.

Nach dem Wiederherstellen der Symbolfolge in der Sende-/Empfängereinheit 60 resultiert hieraus die gezeigte Variation der Positionen der Signalflanken, auch Jitter genannt. Dieser Effekt führt schließlich dazu, dass der in der Zeitmesseinheit 74 gemessene zeitliche Abstand der Signalflanken für ein kurzes Symbol K in einem Intervall zwischen einem Minimalwert T_{Kmin} und einem Maximalwert T_{Kmax} und für ein langes Symbol L in einem Intervall zwischen einem Minimalwert T_{Lmin} und einem Maximalwert T_{Lmax} liegen kann.

Werden die Zeitdauern der Symbole soweit verfälscht, dass sich die Intervalle überschneiden (T_{Kmax} >= T_{Lmin}), so ist bei der im Stand der Technik bekannten Auswertung (einfacher Vergleich des gemessenen zeitlichen Abstands zweier aufeinanderfolgender Signalflanken mit genau einem Entscheidungsintervall je Symbol) keine sichere Zuordnung der Symbole mehr gewährleistet und das Datenübertragungssystem somit nicht mehr funktionsfähig.

Die vorliegende Erfindung berücksichtigt nun die Tatsache, dass sich durch die Übertragung des Datenstroms über den Datenübertragungskanal 50 zwar die Positionen der Flanken ändern, die Datenübertragungsrate insgesamt aber gleich bleibt. Dies führt zu der Erkenntnis, dass die alte Symboldauer Tₐₗₜ die aktuelle Symboldauer T beeinflusst. Dieser Effekt kann genutzt werden, um je Symbol K, L wenigstens zwei Entscheidungsintervalle I_{L1}, I_{K1}; I_{L2}, I_{K2} vorzusehen und in Abhängigkeit von der alten Symboldauer Tₐₗₜ (dem zeitlichen Abstand der Signalflanken der vorhergehenden Messung) für die Zuordnung der Symbole K, L in der Zuordnungseinheit 75 diejenigen Entscheidungsintervalle I_{L1}, I_{K1}; I_{L2}, Iₖ₂ auszuwählen, deren Grenzwerte und/oder Wertebereiche aufgrund von der notwendigen Erhaltung der Datenübertragungsrate mit höherer Wahrscheinlichkeit zutreffen.

### Hierzu ein Beispiel:

War das vorhergehende Symbol ein kurzes Symbol K und lag die alte Symboldauer Tₐₗₜ zwischen T_{Kmin} und T_{K} (der in Figur 2 dargestellten idealen Symboldauer für kurze Symbole), so werden für die Zuordnung einer aktuellen Symboldauer T in der Zuordnungseinheit 75 ein erstes Entscheidungsintervall I_{K1} für kurze Symbole K und ein erstes Entscheidungsintervall I_{L1} für lange Symbole L verwendet. Lag dagegen die alte Symboldauer Tₐₗₜ zwischen T_{K} und T_{Kmax}, so werden für die Zuordnung der aktuellen Symboldauer T zweite Entscheidungsintervalle I_{L2}, I_{K2} verwendet.

Die analoge Vorgehensweise gilt, wenn das vorhergehende Symbol ein langes Symbol L war. Lag die alte Symboldauer Tₐₗₜ zwischen T_{Lmin} und T_{L}, so werden in der Zuordnungseinheit 75 die Entscheidungsintervalle I_{L1}, I_{K1} verwendet, lag die alte Symboldauer Tₐₗₜ zwischen T_{L} und T_{Lmax}, so werden die Entscheidungsintervalle I_{L2}, I_{K2} verwendet.

Aufgrund von der Tatsache, dass die Datenübertragungsrate insgesamt gleich bleiben muss, haben die Entscheidungsintervalle I_{L1}, I_{K1} höhere Grenzwerte als die Entscheidungsintervalle I_{L2}, I_{K2}.

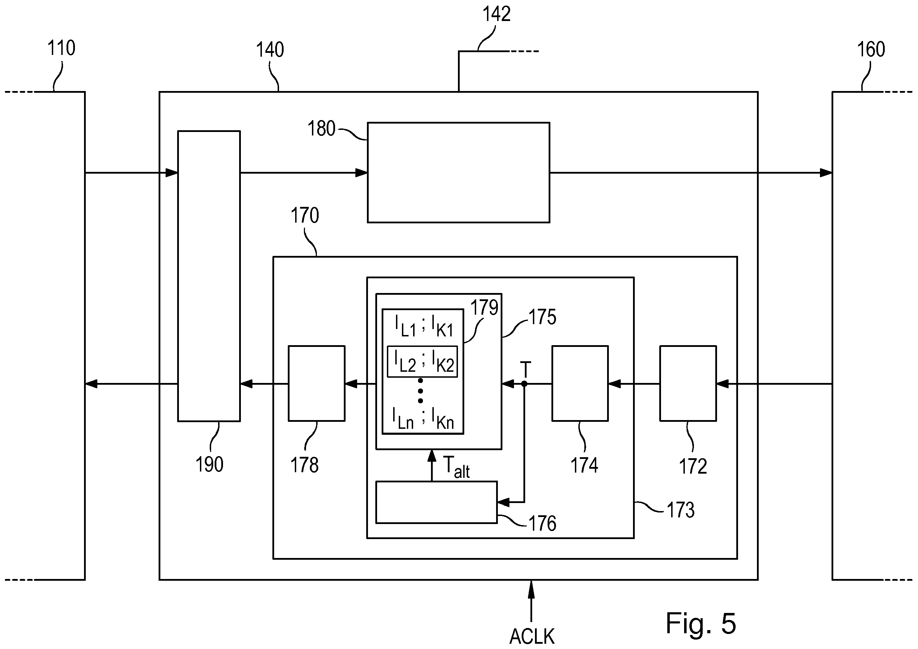

Figur 5 zeigt als Gegenstück zu der in Figur 3 dargestellten Schnittstelleneinheit 40 der Positionsmesseinrichtung 10 ein Blockdiagramm einer entsprechenden Schnittstelleneinheit 140 der Folgeelektronik 100.

Die Schnittstelleneinheiten 40, 140 sind symmetrisch zueinander aufgebaut, daher findet jede Einheit der Schnittstelleneinheit 40 seine Entsprechung in der Schnittstelleneinheit 140. So weist auch die Schnittstelleneinheit 140 eine Leseeinheit 170 mit einer Synchronisationseinheit 172, einer Symbol-Erkennungseinheit 173, umfassend eine Zeitmesseinheit 174, eine Zuordnungseinheit 175 mit einer Speichereinheit 179 und einen Messwertspeicher 176, sowie eine Auswerteeinheit 178 auf. Ebenso sind eine Ausgabeeinheit 180 und eine Kommunikationseinheit 190 vorhanden.

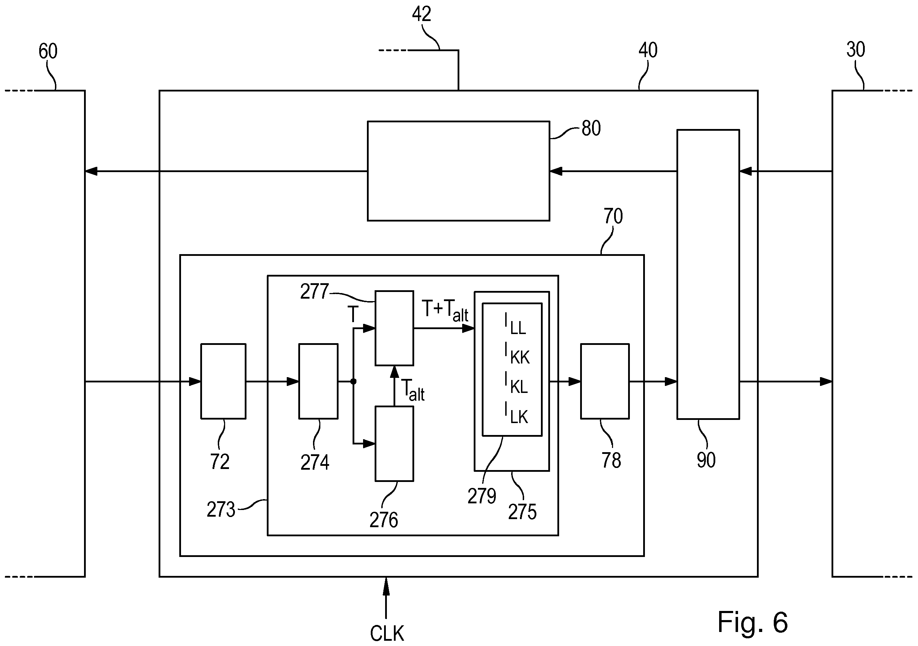

Figur 6 zeigt ein Blockdiagramm einer Schnittstelleneinheit 40 mit einer alternativ ausgestalteten Symbol-Erkennungseinheit 273. Diese Ausführungsform basiert auf der Erkenntnis, dass sich insbesondere bei Codierungen, die wie die Manchester-Codierung eine weitgehend gleichspannungsfreie Datenübertragung aufweisen, die Abweichungen aufeinanderfolgender Symbole gegenläufig verhalten. Dies ergibt sich unter anderem aus Umladevorgängen im Schnittstellenkabel 61. Ist also die aktuelle Symboldauer T einer Messung länger als die ideale Symboldauer T_{K}, T_{L} des zugrundeliegenden Symbols K, L, so ist der Messwert T der darauffolgenden Messung kürzer als die ideale Symboldauer T_{K}, T_{L} des zugrundeliegenden Symbols K, L und umgekehrt. Das gilt, wie in der Beschreibung von Figur 4 bereits ausgeführt, weil die Datenübertragungsrate durch die Übertragung nicht verändert wird.

Die Symbol-Erkennungseinheit 273 weist nun eine Zeitmesseinheit 274 auf, mit der der zeitliche Abstand zweier aufeinanderfolgender Signalflanken messbar ist. Der Messwert T ist einem Messwertspeicher 276 und einer Recheneinheit 277 zugeführt. Die Recheneinheit 277 ist nun geeignet ausgestaltet, um die Summe aus dem aktuellen Messwert T und dem alten Messwert Tₐₗₜ, den sie vom Messwertspeicher 276 erhält, zu bilden und an die Zuordnungseinheit 275 auszugeben. In der Zuordnungseinheit 275 sind nun in der Speichereinheit 279 nur noch maximal so viele Entscheidungsintervalle vorhanden, wie es mögliche Symbolfolgen gibt. Im vorliegenden Beispiel sind es vier Entscheidungsintervalle I_{LL}, I_{KK}, I_{KL,} I_{LK}. Da die Wertebereiche der Entscheidungsintervalle I_{KL,} I_{LK} identisch sind, kann die Anzahl der Entscheidungsintervalle auf drei reduziert werden, beispielsweise auf die Entscheidungsintervalle I_{LL}, I_{KK}, I_{KL}. Das der aktuellen Symboldauer T zuzuordnende Symbol L, K kann nun einfach durch Vergleich der Summe aus aktueller Symboldauer T und alter Symboldauer Tₐₗₜ mit den Entscheidungsintervallen I_{LL}, I_{KK}, I_{KL} ermittelt werden. Liegt das Vergleichsergebnis im Entscheidungsintervall I_{KL,} so entscheidet das zuletzt zugeordnete Symbol über die Zuordnung des aktuellen Symbols K, L.

Der Grundgedanke der Erfindung, für die Zuordnung eines Symbols K, L einen Zeitraum zu berücksichtigen, der auch die alte Symboldauer Tₐₗₜ mit umfasst, bleibt auch in dieser Ausführungsform erhalten. Die der alten Symboldauer Tₐₗₜ zugrundeliegende ideale Symboldauer T_{K}, T_{L} stellt wiederum einen Offsetwert dar. Wie in der Beschreibung von Figur 3 bereits ausgeführt, kann für die Zuordnung des Symbols K, L deshalb der Anteil der idealen Symboldauer T_{K}, T_{L} durch Subtraktion eliminiert oder auf einen einzigen Offsetwert reduziert werden. In diesem Fall sind in der Zuordnungseinheit 275 nur noch zwei Entscheidungsintervalle vorzusehen.

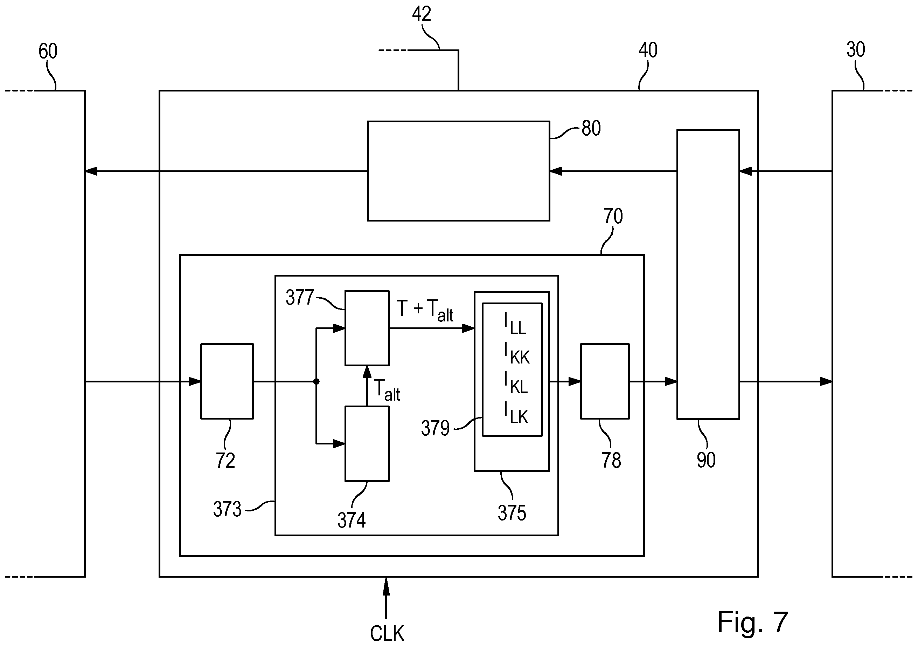

Figur 7 zeigt ein Blockdiagramm einer Schnittstelleneinheit 40 mit einer weiteren, alternativ ausgestalteten Symbol-Erkennungseinheit 373. Die Funktion der Symbol-Erkennungseinheit 373 dieser Variante entspricht der der Symbol-Erkennungseinheit 273 aus Figur 6, lediglich die Summenbildung wird auf andere Weise erreicht.

Die Symbol-Erkennungseinheit 373 weist nun neben der Zeitmesseinheit 374, deren Funktion der der bisher beschriebenen Zeitmesseinheiten 74, 174, 274 entspricht, eine zweite Zeitmesseinheit 377 auf. Diese ist mit dem Messwert T der Zeitmesseinheit 374 ladbar. Die Zeitmessung der zweiten Zeitmesseinheit 377 wird somit mit einem Offset beaufschlagt, der bewirkt, dass das Ergebnis der Zeitmessung wiederum einen Zeitraum umfasst, der der Summe aus alter Symboldauer Tₐₗₜ und aktueller Symboldauer T entspricht. Diese ist der Zuordnungseinheit 375 zugeführt, die eine Speichereinheit 379 mit Entscheidungsintervallen I_{LL}, I_{KK}, I_{KL,} I_{LK}, umfasst, deren Funktion jeweils der der korrespondierenden Einheiten von Figur 6 entspricht.

Auch für die anhand der Figuren 6 und 7 beschriebenen Ausführungsbeispiele gilt, dass der berücksichtigte Zeitraum auf weitere vorausgehende Symboldauern erweitert werden kann.

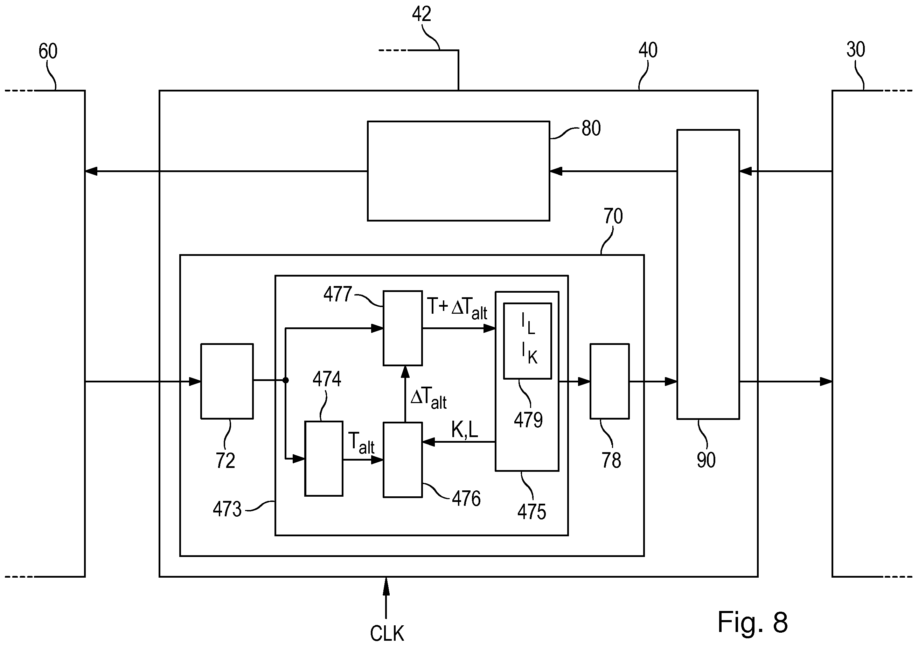

Figur 8 zeigt ein Blockdiagramm einer weiteren Ausführungsform einer Symbol-Zuordnungseinheit 473.

Wie im vorherigen Ausführungsbeispiel umfasst die Symbol-Zuordnungseinheit 473 eine Zeitmesseinheit 474, eine zweite Zeitmesseinheit 477 und eine Zuordnungseinheit 475 mit Speichereinheit 479.

Im Unterschied zum vorherigen Ausführungsbeispiel ist weiter eine Recheneinheit 476 vorgesehen,
Die Recheneinheit 476 dient dazu, für die Zuordnung des Symbols K, L in der Zuordnungseinheit 475 den Anteil der idealen Symboldauer T_{K}, T_{L} an der alten Symboldauer Tₐₗₜ durch Subtraktion zu eliminieren. Hierzu ist ihr von der Zuordnungseinheit die Information über das letzte zugeordnete Symbol K, L zugeführt. Die ermittelte Abweichung ΔTₐₗₜ ist der zweiten Zeitmesseinheit 477 zugeführt und wird als Offset für die Zeitmessung verwendet. Das Ergebnis der Zeitmessung T + ΔTₐₗₜ ist der Zuordnungseinheit 475 zugeführt.

Alternativ kann der Anteil der idealen Symboldauer T_{K}, T_{L} an der alten Symboldauer Tₐₗₜ in der Recheneinheit 476 aber auch auf einen einzigen Offsetwert reduziert werden, der als Konstante entweder der Symboldauer eines idealen langen Symbols T_{L} oder der Symboldauer eines idealen kurzen Symbols T_{K} entspricht. Dieser Offset kann in der Zuordnungseinheit 475 einfach berücksichtigt werden. In jedem Fall sind in der Zuordnungseinheit 475 nur noch zwei Entscheidungsintervalle I_{L}, I_{K} vorzusehen.

Auch dieses Ausführungsbeispiel kann auf einen zu berücksichtigenden Zeitraum ausgedehnt werden, der weitere vorausgehende Symboldauern umfasst.

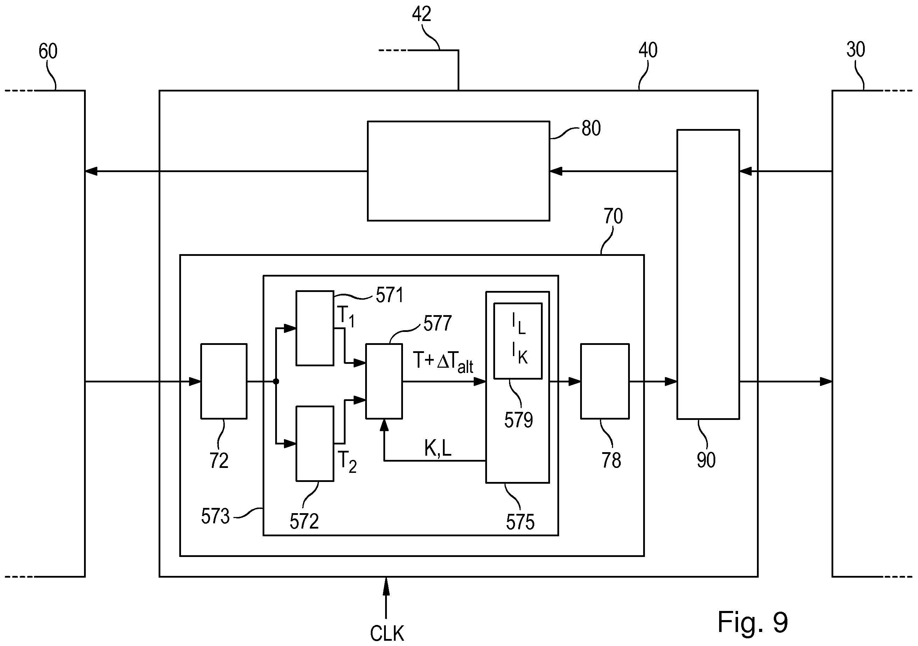

Figur 9 zeigt ein Blockdiagramm einer weiteren Ausführungsform einer Symbol-Zuordnungseinheit 573.

Die Symbol-Erkennungseinheit 573 umfasst eine erste Zeitmesseinheit 571 und eine zweite Zeitmesseinheit 572, eine Recheneinheit 577, sowie eine Zuordnungseinheit 575 mit Speichereinheit 579. Zuordnungseinheit 575 und Speichereinheit 579 sind mit den korrespondierenden Einheiten des vorhergehenden Ausführungsbeispiels identisch.

Die erste Zeitmesseinheit 571 und die zweite Zeitmesseinheit 572 sind so ausgestaltet, dass sie einen Zeitraum messen, der bereits zwei Symboldauern (also eine aktuelle Symboldauer T und eine alte Symboldauer Tₐₗₜ) umfasst. Im konkreten Beispiel kann die erste Zeitmesseinheit 571 so ausgestaltet sein, dass sie eine erste Zeitdauer T1 von einer steigenden Signalflanke bis zur nächsten steigenden Signalflanke des Datenstroms misst, während die zweite Zeitmesseinheit 572 so ausgestaltet ist, dass sie eine zweite Zeitdauer T2 von einer fallenden Signalflanke bis zur nächsten fallenden Signalflanke des Datenstroms misst.

Die Zeitdauern T1, T2 sind jeweils der Recheneinheit 577 zugeführt. Sie entsprechen jeweils einer Summe aus einer aktuellen Symboldauer T und einer alten Symboldauer Tₐₗₜ, wie sie in vorhergehenden Ausführungsbeispielen schon erläutert wurden und werden abwechselnd ausgewertet. Daraus folgt, dass, wie im vorherigen Ausführungsbeispiel, der Anteil der idealen Symboldauer T_{K}, T_{L} an der alten Symboldauer Tₐₗₜ in der Recheneinheit 577 durch Subtraktion eliminiert oder auf einen einzigen Offsetwert reduziert werden kann. Das Ergebnis ist wiederum die Summe aus aktueller Symboldauer T und der Abweichung ΔTₐₗₜ (ggf. mit einem Offset behaftet), die an die Zuordnungseinheit 575 ausgegeben wird.

Alternativ kann die Auswertung analog zu den anhand der Figuren 6 und 7 beschriebenen Ausführungsbeispielen erfolgen, indem die Zeitdauern T1, T2 abwechselnd einer Zuordnungseinheit 275, 375 zugeführt werden.

Durch das Vorsehen weiterer Zeitmesseinheiten und Erweiterung des Messbereichs der Zeitmesseinheiten auf eine größere Anzahl von Signalflanken kann, bei entsprechender Anpassung der Recheneinheit, auch dieses Ausführungsbeispiel auf einen zu berücksichtigenden Zeitraum ausgedehnt werden, der weitere vorausgehende Symboldauern umfasst.

Auch die Schnittstelleneinheiten der anhand der Figuren 5 bis 9 beschriebenen Ausführungsbeispiele sind in der Folgeelektronik einsetzbar.

Ausgehend vom Grundgedanken, für die Zuordnung von Symbolen einen Zeitraum zu berücksichtigen, der eine Symboldauer eines aktuell zuzuordnenden Symbols und wenigstens eine Symboldauer des vorhergehenden Symbols umfasst, sind im Rahmen der vorliegenden Erfindung selbstverständlich weitere, alternative Ausführungsformen realisierbar.

Neben Positionsmesseinrichtungen 10 und deren Folgeelektroniken 100 ist die vorliegende Erfindung auch für weitere Geräte der Automatisierungstechnik geeignet.

## Patentansprüche

1. Verfahren zum Einlesen eines seriellen Datenstroms in einem Gerät der Automatisierungstechnik (10, 100), wobei der Datenstrom in einer Weise codiert ist, dass er wenigstens zwei Symbole (K, L) umfasst, die durch den zeitlichen Abstand zwischen zwei aufeinanderfolgenden Signalflanken unterscheidbar sind und der Datenstrom einer Leseeinheit (70, 170) zugeführt ist, die eine Symbol-Erkennungseinheit (73, 173, 273, 373, 473, 573) umfasst, die der zeitlichen Abfolge der Signalflanken Symbole (K, L) zuordnet, **dadurch gekennzeichnet, dass** für die Zuordnung eines Symbols (K, L) ein Zeitraum berücksichtigt wird, der eine aktuelle Symboldauer (T) des aktuell zuzuordnenden Symbols und wenigstens eine alte Symboldauer (Tₐₗₜ) des vorhergehenden Symbols umfasst.

2. Verfahren nach Anspruch 1, wobei der Symbol-Erkennungseinheit (73, 173, 273, 373, 473, 573) eine Synchronisierungseinheit (72, 172) vorgeschaltet ist, in der der serielle Datenstrom mit einem Arbeitstaktsignal (CLK, ACLK) synchronisiert wird und der Symbol-Erkennungseinheit (73, 173, 273, 373, 473, 573) der synchronisierte Datenstrom zugeführt wird.

3. Verfahren nach einem der vorhergehenden Ansprüche, wobei die Symbol-Erkennungseinheit (73, 173, 273, 373, 473, 573) die Information über die Abfolge der Symbole (K, L) zur weiteren Auswertung an eine Auswerteeinheit (78) ausgibt.

4. Verfahren nach einem der vorhergehenden Ansprüche, wobei die Symbol-Erkennungseinheit (73, 173, 273, 373, 473, 573) eine Zuordnungseinheit (75, 175, 275, 375, 475, 575) umfasst, der
• die aktuelle Symboldauer (T) und wenigstens die alte Symboldauer (Tₐₗₜ), oder
• eine Summe aus der aktuellen Symboldauer (T) und wenigstens der alten Symboldauer (Tₐₗₜ), oder
• eine Summe aus der aktuellen Symboldauer (T) und einer Abweichung (ΔTₐₗₜ) wenigstens der alten Symboldauer (Tₐₗₜ) von einer idealen Zeitdauer (T_{K}, T_{L}), oder
• eine Summe aus der aktuellen Symboldauer (T), der Abweichung (ΔTₐₗₜ) wenigstens der alten Symboldauer (Tₐₗₜ) von einer idealen Zeitdauer (T_{K}, T_{L}) und einem Offsetwert (T_{K}, T_{L})
zugeführt wird und in der Zuordnungseinheit auf der Basis dieser Werte der aktuellen Symboldauer (T) ein Symbol (K, L) zugeordnet wird.

5. Verfahren nach Anspruch 4, wobei die Zuordnung durch Vergleich mit Entscheidungsintervallen (I_{L1}, I_{K1}; I_{L2}, I_{K2}; ... ; I_{Ln}, I_{Kn}; I_{LL}, I_{KK}, I_{LK}, I_{KL}; I_{L}, I_{K}) erfolgt.

6. Verfahren nach einem der vorhergehenden Ansprüche, wobei die Codierung eine Manchester-Codierung ist, bei der der Datenstrom eine Abfolge von kurzen Symbolen (K) und langen Symbolen (L) aufweist.

7. Verfahren nach einem der vorhergehenden Ansprüche, wobei die Entscheidungsintervalle (I_{L1}, I_{K1}; I_{L2}, I_{K2}; ... ; I_{Ln}, I_{Kn}; I_{LL}, I_{KK}, I_{LK}, I_{KL}; I_{L}, I_{K}) installationsabhängig sind und in einer Speichereinheit (79, 179, 279, 379) gespeichert werden.

8. Vorrichtung zum Einlesen eines seriellen Datenstroms in einem Gerät der Automatisierungstechnik (10, 100), wobei der Datenstrom in einer Weise codiert ist, dass er wenigstens zwei Symbole (K, L) umfasst, die durch den zeitlichen Abstand zwischen zwei aufeinanderfolgenden Signalflanken unterscheidbar sind und der Datenstrom einer Leseeinheit (70, 170) zugeführt ist, die eine Symbol-Erkennungseinheit (73, 173, 273, 373, 473, 573) umfasst, die der zeitlichen Abfolge der Signalflanken Symbole (K, L) zuordnet, **dadurch gekennzeichnet, dass** in der Symbol-Erkennungseinheit (73, 173, 273, 373, 473, 573) ein Symbol (K, L) unter Berücksichtigung eines Zeitraums, der eine aktuelle Symboldauer (T) des aktuell zuzuordnenden Symbols und wenigstens eine alte Symboldauer (Tₐₗₜ) des vorhergehenden Symbols umfasst, zuordenbar ist.

9. Vorrichtung nach Anspruch 8, wobei der Symbol-Erkennungseinheit (73, 173, 273, 373, 473, 573) eine Synchronisierungseinheit (72, 172) vorgeschaltet ist, mit der der serielle Datenstrom mit einem Arbeitstaktsignal (CLK, ACLK) synchronisierbar und der synchronisierte Datenstrom der Symbol-Erkennungseinheit (73, 173, 273, 373, 473, 573) zuführbar ist.

10. Vorrichtung nach einem der Ansprüche 8 bis 9, wobei die Symbol-Erkennungseinheit (73, 173, 273, 373, 473, 573) die Information über die Abfolge der Symbole (K, L) zur weiteren Auswertung an eine Auswerteeinheit (78) ausgibt.

11. Vorrichtung nach einem der Ansprüche 8 bis 10, wobei die Symbol-Erkennungseinheit (73, 173, 273, 373, 473, 573) eine Zuordnungseinheit (75, 175, 275, 375, 475, 575) umfasst, der
• die aktuelle Symboldauer (T) und wenigstens die alte Symboldauer (Tₐₗₜ), oder
• eine Summe aus der aktuellen Symboldauer (T) und wenigstens der alten Symboldauer (Tₐₗₜ), oder
• eine Summe aus der aktuellen Symboldauer (T) und einer Abweichung (ΔTₐₗₜ) wenigstens der alten Symboldauer (Tₐₗₜ) von einer idealen Zeitdauer (T_{K}, T_{L}), oder
• eine Summe aus der aktuellen Symboldauer (T), der Abweichung (ΔTₐₗₜ) wenigstens der alten Symboldauer (Tₐₗₜ) von einer idealen Zeitdauer (T_{K}, T_{L}) und einem Offsetwert (T_{K}, T_{L})
zugeführt ist und in der Zuordnungseinheit auf der Basis dieser Werte der aktuellen Symboldauer (T) ein Symbol (K, L) zuordenbar ist.

12. Vorrichtung nach Anspruch 11, wobei die Zuordnung durch Vergleich mit Entscheidungsintervallen (I_{L1}, I_{K1}; I_{L2}, I_{K2}; ... ; I_{Ln}, I_{Kn}; I_{LL}, I_{KK}, I_{LK}, I_{KL}; I_{L}, I_{K}) erfolgt.

13. Vorrichtung nach einem der Ansprüche 11 oder 12, wobei die Symbol-Erkennungseinheit (73, 173, 273, 373, 473, 573) Mittel zum Generieren der Werte, auf deren Basis die Zuordnung des Symbols (K, L) erfolgt, umfasst.

14. Vorrichtung nach einem der Ansprüche 8 bis 13, wobei die Codierung eine Manchester-Codierung ist, bei der der Datenstrom eine Abfolge von kurzen Symbolen (K) und langen Symbolen (L) aufweist.

15. Vorrichtung nach einem der Ansprüche 8 bis 14, wobei die Entscheidungsintervalle (I_{L1}, I_{K1}; I_{L2}, I_{K2}; ... ; I_{Ln}, I_{Kn}; I_{LL}, I_{KK}, I_{LK}, I_{KL}; I_{L}, I_{K}) installationsabhängig und in einer Speichereinheit (79, 179, 279, 379) speicherbar sind.

## Claims

1. Method for reading in a serial data stream in an automation engineering device (10, 100), wherein the data stream is coded such that it comprises at least two symbols (K, L) that are distinguishable by the interval of time between two successive signal edges, and the data stream is supplied to a reading unit (70, 170) that comprises a symbol detection unit (73, 173, 273, 373, 473, 573) that assigns symbols (K, L) to the temporal sequence of the signal edges, **characterized in that** the assignment of a symbol (K, L) involves a period of time being taken into consideration that comprises a present symbol duration (T) of the symbol presently needing to be assigned and at least one old symbol duration (T_{old}) of the preceding symbol.

2. Method according to Claim 1, wherein the symbol detection unit (73, 173, 273, 373, 473, 573) has an upstream synchronization unit (72, 172) in which the serial data stream is synchronized with an operating clock signal (CLK, ACLK) and the symbol detection unit (73, 173, 273, 373, 473, 573) is supplied with the synchronized data stream.

3. Method according to either of the preceding claims, wherein the symbol detection unit (73, 173, 273, 373, 473, 573) outputs information about the sequence of the symbols (K, L) to an evaluation unit (78) for the purpose of further evaluation.

4. Method according to one of the preceding claims, wherein the symbol detection unit (73, 173, 273, 373, 473, 573) comprises an assigning unit (75, 175, 275 375, 475, 575) that is supplied with
• the present symbol duration (T) and at least the old symbol duration (T_{old}), or
• a sum of the present symbol duration (T) and at least the old symbol duration (T_{old}), or
• a sum of the present symbol duration (T) and a divergence (ΔT_{old}) of at least the old symbol duration (T_{old}) from an ideal period (T_{K}, T_{L}), or
• a sum of the present symbol duration (T), the divergence (ΔT_{old}) of at least the old symbol duration (T_{old}) from an ideal period (T_{K}, T_{L}) and an offset value (T_{K}, T_{L}),
and a symbol (K, L) is assigned in the assigning unit on the basis of these values of the present symbol duration (T).

5. Method according to Claim 4, wherein the assignment is made by means of comparison with decision intervals (I_{L1}, I_{K1}; I_{L2}, I_{K2}; ...; I_{Ln}, I_{Kn}; I_{LL}, I_{KK}, I_{LK}, I_{KL}; I_{L}, I_{K}).

6. Method according to one of the preceding claims, wherein the coding is a Manchester coding in which the data stream has a sequence of short symbols (K) and long symbols (L).

7. Method according to one of the preceding claims, wherein the decision intervals (I_{L1}, I_{K1}; I_{L2}, I_{K2}; ...; I_{Ln}, I_{Kn}; I_{LL}, I_{KK}, I_{LK}, I_{KL}; I_{L}, I_{K}) are installation-dependent and are stored in a memory unit (79, 179, 279, 379).

8. Apparatus for reading in a serial data stream in an automation engineering device (10, 100), wherein the data stream is coded such that it comprises at least two symbols (K, L) that are distinguishable by the interval of time between two successive signal edges, and the data stream is supplied to a reading unit (70, 170) that comprises a symbol detection unit (73, 173, 273, 373, 473, 573) that assigns symbols (K, L) to the temporal sequence of the signal edges, **characterized in that** a symbol (K, L) is assignable in the symbol detection unit (73, 173, 273, 373, 473, 573) by taking into consideration a period of time that comprises a present symbol duration (T) of the symbol presently needing to be assigned and at least one old symbol duration (T_{old}) of the preceding symbol.

9. Apparatus according to Claim 8, wherein the symbol detection unit (73, 173, 273, 373, 473, 573) has an upstream synchronization unit (72, 172) by means of which the serial data stream is synchronizable with an operating clock signal (CLK, ACLK) and the synchronized data stream is suppliable to the symbol detection unit (73, 173, 273, 373, 473, 573).

10. Apparatus according to either of Claims 8 and 9, wherein the symbol detection unit (73, 173, 273, 373, 473, 573) outputs the information about the sequence of the symbols (K, L) to an evaluation unit (78) for the purpose of further evaluation.

11. Apparatus according to one of Claims 8 to 10, wherein the symbol detection unit (73, 173, 273, 373, 473, 573) comprises an assigning unit (75, 175, 275 375, 475, 575) that is supplied with
• the present symbol duration (T) and at least the old symbol duration (T_{old}), or
• a sum of the present symbol duration (T) and at least the old symbol duration (T_{old}), or
• a sum of the present symbol duration (T) and a divergence (ΔT_{old}) of at least the old symbol duration (T_{old}) from an ideal period (T_{K}, T_{L}), or
• a sum of the present symbol duration (T), the divergence (ΔT_{old}) of at least the old symbol duration (T_{old}) from an ideal period (T_{K}, T_{L}) and an offset value (T_{K}, T_{L}),
and a symbol (K, L) is assignable in the assigning unit on the basis of these values of the present symbol duration (T).

12. Apparatus according to Claim 11, wherein the assignment is made by means of comparison with decision intervals (I_{L1}, I_{K1}; I_{L2}, I_{K2}; ...; I_{Ln}, I_{Kn}; I_{LL}, I_{KK}, I_{LK}, I_{KL}; I_{L}, I_{K}).

13. Apparatus according to either of Claims 11 and 12, wherein the symbol detection unit (73, 173, 273, 373, 473, 573) comprises means for generating the values on the basis of which the assignment of the symbol (K, L) is made.

14. Apparatus according to one of Claims 8 to 13, wherein the coding is a Manchester coding in which the data stream has a sequence of short symbols (K) and long symbols (L).

15. Apparatus according to one of Claims 8 to 14, wherein the decision intervals (I_{L1}, I_{K1}; I_{L2}, I_{K2}; ...; I_{Ln}, I_{Kn}; I_{LL}, I_{KK}, I_{LK}, I_{KL}; I_{L}, I_{K}) are installation-dependent and are storable in a memory unit (79, 179, 279, 379).

## Revendications

1. Procédé de lecture d'un flux de données en série dans un appareil de l'automatisme (10, 100), le flux de données étant codé d'une manière telle qu'il comporte au moins deux symboles (K, L) qui peuvent être différenciés par l'écart dans le temps entre deux fronts de signal successifs et le flux de données étant acheminé à une unité de lecture (70, 170) qui comporte une unité de reconnaissance de symbole (73, 173, 273, 373, 473, 573), laquelle attribue des symboles (K, L) à la séquence chronologique des fronts de signal, **caractérisé en ce qu'**une période est prise en compte pour l'attribution d'un symbole (K, L), laquelle comprend une durée de symbole actuelle (T) d'un symbole actuellement à attribuer et au moins une ancienne durée de symbole (Tₐₗₜ) du symbole précédent.

2. Procédé selon la revendication 1, une unité de synchronisation (72, 172) étant branchée en amont de l'unité de reconnaissance de symbole (73, 173, 273, 373, 473, 573), dans laquelle le flux de données en série est synchronisé avec un signal d'horloge de travail (CLK, ACLK) et le flux de données synchronisé est acheminé à l'unité de reconnaissance de symbole (73, 173, 273, 373, 473, 573).

3. Procédé selon l'une des revendications précédentes, l'unité de reconnaissance de symbole (73, 173, 273, 373, 473, 573) délivrant l'information à propos de la séquence des symboles (K, L) à une unité d'interprétation (78) en vue d'une interprétation ultérieure.

4. Procédé selon l'une des revendications précédentes, l'unité de reconnaissance de symbole (73, 173, 273, 373, 473, 573) comportant une unité d'attribution (75, 175, 275, 375, 475, 575) à laquelle sont acheminées
* la durée de symbole actuelle (T) et au moins l'ancienne durée de symbole (Tₐₗₜ) ou
* une somme de la durée de symbole actuelle (T) et d'au moins l'ancienne durée de symbole (Tₐₗₜ) ou
* une somme de la durée de symbole actuelle (T) et d'un écart (ΔTₐₗₜ) d'au moins l'ancienne durée de symbole (Tₐₗₜ) par rapport à une durée idéale (T_{K}, T_{L}) ou
* une somme de la durée de symbole actuelle (T), de l'écart (ΔTₐₗₜ) d'au moins l'ancienne durée de symbole (Tₐₗₜ) par rapport à une durée idéale (T_{K}, T_{L}) et une valeur de décalage (T_{K}, T_{L})
et un symbole (K, L) est attribué à la durée de symbole actuelle (T) dans l'unité d'attribution sur la base de ces valeurs.

5. Procédé selon la revendication 4, l'attribution s'effectuant par comparaison avec des intervalles de décision (I_{L1}, I_{K1} ; I_{L2}, I_{K2} ; ... ; I_{Ln}, I_{Kn} ; I_{LL}, I_{KK}, I_{LK}, I_{KL} ; I_{L}, I_{K}).

6. Procédé selon l'une des revendications précédentes, le codage étant un codage Manchester avec lequel le flux de données possède une séquence de symboles courts (K) et de symboles longs (L).

7. Procédé selon l'une des revendications précédentes, les intervalles de décision (I_{L1}, I_{K1} ; I_{L2}, I_{K2} ; ... ; I_{Ln}, I_{Kn} ; I_{LL}, I_{KK}, I_{LK}, I_{KL} ; I_{L}, I_{K}) étant dépendants de l'installation et étant mémorisés dans une unité de mémoire (79, 179, 279, 379).

8. Dispositif de lecture d'un flux de données en série dans un appareil de l'automatisme (10, 100), le flux de données étant codé d'une manière telle qu'il comporte au moins deux symboles (K, L) qui peuvent être différenciés par l'écart dans le temps entre deux fronts de signal successifs et le flux de données étant acheminé à une unité de lecture (70, 170) qui comporte une unité de reconnaissance de symbole (73, 173, 273, 373, 473, 573), laquelle attribue des symboles (K, L) à la séquence chronologique des fronts de signal, **caractérisé en ce qu'**un symbole (K, L) peut être attribué dans l'unité de reconnaissance de symbole (73, 173, 273, 373, 473, 573) en tenant compte d'une période, laquelle comprend une durée de symbole actuelle (T) d'un symbole actuellement à attribuer et au moins une ancienne durée de symbole (Tₐₗₜ) du symbole précédent.

9. Dispositif selon la revendication 8, une unité de synchronisation (72, 172) étant branchée en amont de l'unité de reconnaissance de symbole (73, 173, 273, 373, 473, 573), avec laquelle le flux de données en série peut être synchronisé avec un signal d'horloge de travail (CLK, ACLK) et le flux de données synchronisé peut être acheminé à l'unité de reconnaissance de symbole (73, 173, 273, 373, 473, 573).

10. Dispositif selon l'une des revendications 8 à 9, l'unité de reconnaissance de symbole (73, 173, 273, 373, 473, 573) délivrant l'information à propos de la séquence des symboles (K, L) à une unité d'interprétation (78) en vue d'une interprétation ultérieure.

11. Dispositif selon l'une des revendications 8 à 10, l'unité de reconnaissance de symbole (73, 173, 273, 373, 473, 573) comportant une unité d'attribution (75, 175, 275, 375, 475, 575) à laquelle sont acheminées
* la durée de symbole actuelle (T) et au moins l'ancienne durée de symbole (Tₐₗₜ) ou
* une somme de la durée de symbole actuelle (T) et d'au moins l'ancienne durée de symbole (Tₐₗₜ) ou
* une somme de la durée de symbole actuelle (T) et d'un écart (ΔTₐₗₜ) d'au moins l'ancienne durée de symbole (Tₐₗₜ) par rapport à une durée idéale (T_{K}, T_{L}) ou
* une somme de la durée de symbole actuelle (T), de l'écart (ΔTₐₗₜ) d'au moins l'ancienne durée de symbole (Tₐₗₜ) par rapport à une durée idéale (T_{K}, T_{L}) et une valeur de décalage (T_{K}, T_{L})
et un symbole (K, L) peut être attribué à la durée de symbole actuelle (T) dans l'unité d'attribution sur la base de ces valeurs.

12. Dispositif selon la revendication 11, l'attribution s'effectuant par comparaison avec des intervalles de décision (I_{L1}, I_{K1} ; I_{L2}, I_{K2} ; ... ; I_{Ln}, I_{Kn} ; I_{LL}, I_{KK}, I_{LK}, I_{KL} ; I_{L}, I_{K}).

13. Dispositif selon l'une des revendications 11 et 12, l'unité de reconnaissance de symbole (73, 173, 273, 373, 473, 573) comportant des moyens destinés à générer les valeurs sur la base desquelles s'effectue l'attribution du symbole (K, L).

14. Dispositif selon l'une des revendications 8 à 13, le codage étant un codage Manchester avec lequel le flux de données possède une séquence de symboles courts (K) et de symboles longs (L).

15. Dispositif selon l'une des revendications 8 à 14, les intervalles de décision (I_{L1}, I_{K1} ; I_{L2}, I_{K2} ; ... ; I_{Ln}, I_{Kn} ; I_{LL}, I_{KK}, I_{LK}, I_{KL} ; I_{L}, I_{K}) étant dépendants de l'installation et pouvant être mémorisés dans une unité de mémoire (79, 179, 279, 379).
